(19) Europäisches Patentamt
European Patent Office
Office européen des brevets

(11) Publication number: **0 297 179 B1**

# (12) EUROPEAN PATENT SPECIFICATION

(45) Date of publication of patent specification: **11.09.91**

(51) Int. Cl.$^5$: **C08F 2/32**

(21) Application number: **87201267.9**

(22) Date of filing: **03.07.87**

## (54) Process for the production of inverted micelles.

(43) Date of publication of application:
**04.01.89 Bulletin 89/01**

(45) Publication of the grant of the patent:
**11.09.91 Bulletin 91/37**

(84) Designated Contracting States:
**BE DE FR GB**

(56) References cited:
**DE-B- 1 301 065**
**US-A- 3 108 979**
**US-A- 4 539 368**

(73) Proprietor: **AGFA-GEVAERT naamloze vennootschap**
**Septestraat 27**
**B-2510 Mortsel(BE)**

(72) Inventor: **Leenders, Luc Herwig**
**Lichtaartseweg 182,**
**B-2410 Herentals(BE)**
Inventor: **Delzenne, Gerard Albert**
**Graaf Charles Cornetlaan 40,**
**B-2232 's-Gravenwezel(BE)**
Inventor: **De Schryver, Frans Carl**
**Minnezang 9,**
**B-3202 Linden(BE)**
Inventor: **Voortmans, Gilbert Johannes**
**Bergstraat 1A,**
**B-3211 Tielt-Winge(BE)**

**EP 0 297 179 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to inverse emulsions of polymerizable substances and microcapsules prepared therewith.

As is generally known the two most common types of emulsions are "oil-in-water" (O/W) and "water-in-oil" (W/O). In each of these designations the first mentioned substance constitutes the dispersed phase and the word "oil" signifies any liquid immiscible with or sparingly soluble in water.

Water-in-oil emulsions of monomers have been used for the production of polymers as described e.g. in US-P 3,284,393. In such method a water-in-oil emulsifying agent is used to emulsify the aqueous liquid in the lipophilic phase. The process has proven succesful for the production of nonionic polymers and has been adapted for the production of anionic polymers as described in US-P 4,539,368 wherein the monomers are emulsified with the aid of a mixture of nonionic surfactant and an anionic surfactant such as an anionic sulfosuccinate surfactant.

Water-in-oil polymerization is further known from French Patent No. 2,529,895 according to which polymerization in "inverse emulsion" proceeds to form a copolymer of acrylamide/dimethylaminoethyl acrylate in salt or quaternized form using a suitable emulsifying agent such as the mono-oleate of sorbitol, starting the polymerization with hydroperoxide of cumene and thionyl chloride.

By the presence of an emulsifying agent the surface tension in the W/O interface is lowered and at a certain concentration, called critical micelle concentration (CMC), an aggregation of molecules is formed wherein the polar part of the surfactant is penetrating in the aqueous phase and the apolar part is oriented towards the lipophilic phase forming thereby so-called "inverted or reverse micelles". The monomers are polymerized inside the aqueous phase and no polymer skin is formed that envelops the aqueous core material of the inverted micelle.

It is an object of the present invention to provide a method for the production of inverted micelles by means of monomers that can form micelles without additional emulsifying agent.

It is another object of the present invention to provide a method for the production of inverted micelles wherein a polymer layer surrounds the aqueous phase core of the micelle.

It is a further object of the present invention to provide inverted micelles for the production of microcapsules in which the aqueous core surrounded by a polymer layer contains (a) chemical substance(s) that can penetrate in or interact with the environment containing the microcapsules after permeation or rupturing of the polymer layer.

Other objects and advantages of the present invention will appear from the further description and examples.

In accordance with the present invention a process for the production of inverted micelles is provided by preparing a water-in-oil emulsion of an ionic monomer that can be polymerized, characterized in that the ionic monomer corresponds to the following general formula (I) :

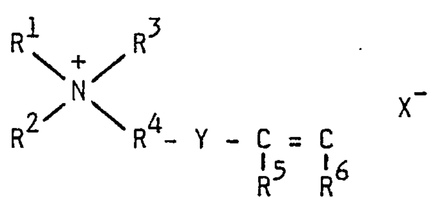

wherein :

each of $R^1$ and $R^2$ - same or different - represents an alkyl group having at least 6 carbon atoms in straight line,

$R^3$ represents a lower (C1-C2) alkyl group,

$R^4$ represents 1 to 4 methylene groups,

each of $R^5$ and $R^6$ - same or different - represents hydrogen or an alkyl group,

Y represents -O-CO-, -CO-O-, -NH-CO-, -CO-O-$CH_2$-, -O-PO($OR^3$)- or a phenylene group, and

X- is an anion, e.g. chloride;

the concentration of said ionic monomer in the oil phase being sufficient to obtain critical micelle concentration, without aid of additional non-polymerizable emulsifying agent.

The capacity of ionic monomers to form inverted micelles can be determined by usual tests known for determining critical micelle concentration (CMC). As is known to one skilled in the art some of the

properties of a surfactant solution, such as refractive index, light scattering, interfacial tension, viscosity, dye solubilization and absorption of fluorescent substance usually vary linearly with increasing concentration up to the CMC at which point there is a break in these properties [ref. Figure 4 on page 354 of Encyclopedia of Chemical Technology, Kirk-Othmer - 3rd. ed. Vol. 22, A Wiley Interscience Publication - New York (1983)].

The monomers of the above general formula (I) can be prepared according to synthesis techniques known to one skilled in the art, e.g. as described in US-P 3,977,983 and published EP-A 0 168 749.

The preparation of a monomer being particularly suited for polymerization in reverse micelle structure is given hereinafter for illustrative purposes.

Reaction scheme :

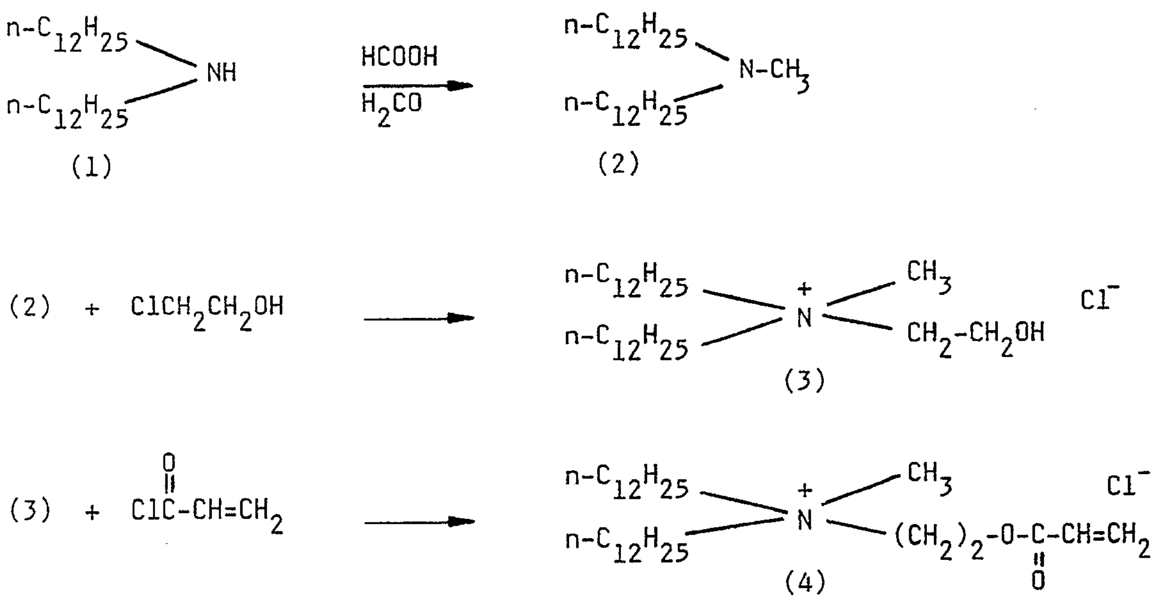


(1) (2)

(2) + $ClCH_2CH_2OH$ (3)

(3) + (4)

Step 1

To a solution of 77 g of di-n-dodecylamine in 200 ml of ethanol were dropwise added 49 ml of a 85 % wt solution of formic acid. The temperature of the solution was kept at 40 °C. Thereupon 46 ml of a 46 % wt solution of formaldehyde was added at 60 °C. The solution was boiled with reflux for 6 h. The cooled down reaction mixture was neutralized with an aqueous sodium hydroxide solution. The organic upper layer was separated, dried and distilled at 183 °C under a pressure of 0.35 mm Hg. Yield of N-methyl-di-n-dodecylamine : 80%.

Step 2

The N-methyl-di-n-dodecylamine was quaternized by reaction with a tenfold excess of chlorohydrin at 60 °C during 60 h.

The reaction product was purified by crystallization from ethyl acetate.

Step 3

The quaternized di-n-dodecylamine was transformed into the monomer (4) by dissolving 5 g of product (3) in 50 ml of dry dichloromethane in the presence of 1 equivalent of triethylamine. To this mixture 2.5 g of methacryloyl chloride was added while cooling and in the presence of 2,4,6-tri-t.butyl-phenol as oxygen-inhibitor. After stirring for half an hour at 0 °C the temperature of the mixture was allowed to rise to room temperature and was kept overnight.

The reaction product (4) was purified on a silica column using a chloroform/methanol (95:5 by volume) as eluent.

Further purification proceeded by crystallization from acetone.

The oil phase wherein the ionic monomers have to be soluble may comprise essentially any inert hydrophobic liquid and includes, e.g. a hydrocarbon or halogenated hydrocarbon liquid. The choice of a best suitable oil phase solvent will depend on the structure of the monomer. Typically useful oil phase materials are benzene, toluene, kerozenes, naphthas, paraffinic solvents and the like.

The concentration of said monomers in the oil phase for use in the formation of inverted micelles is at least sufficient to obtain critical micelle concentration as found e.g. by a discontinuity in the fluorescence decay time curve of a fluorescent substance such as sodium pyrene sulfonate associated with the micelles. The relative proportions of water to oil have to be such that water-in-oil emulsions are obtained by common stirring techniques.

The following Example 1 illustrates the formation of inverted micelles with the above prepared monomer (4).

EXAMPLE 1

A 0.05 mole solution of monomer (4) in toluene was prepared. To said solution small amounts (0.1 % by volume) of water were added while sonicating the mixture for 15 min at 20 °C.

The determination of Critical Micel Concentration (CMC).

A series of liquids containing the monomer (4) in micellar state solutions with concentrations ranging from 0.05 to $10^{-6}$ mole per liter were made for test purposes. To these solutions a constant quantity ($10^{-6}$ mole per liter) of sodium pyrenesulfonate were added. The fluorescence decay time of sodium pyrenesulfonate undergoes a sharp decrease at the critical micel concentration of the monomer. The determination of the fluorescence decay of each probe was measured by single photon counting technique. In order to find the CMC, i.e. concentration of monomer (4) at which it obtains micellar structure, the relative longest decay time ($\tau_d$) expressed in percental values is plotted as a function of the logarithm of the monomer concentration (log [M]). From the obtained curve, $\tau_d$ versus log [M] can be learned that their is a sharp bend in the curve at the CMC (the log values being exponential values change order by a factor 2).

In the accompanying drawing said curve is illustrated for the above prepared monomer.

The polymerization of the monomers once arranged in micelle structure can be carried out by free radical polymerization known for ethylenic compounds. Suitable free radical generating compounds include peroxide initiators, e.g. benzoyl peroxide, azonitrile initiators, e.g. azo bisisobutyronitrile, ammonium or potassium persulphate and the like.

The polymerization initiation may proceed by thermally or photochemically formed radicals.

Generally the amount of initiator will range from 0.002 to 0.2 wt % of monomer depending upon the type and solubility of the monomer and initiator. The initiator may be either oil or water soluble. In the case it is oil soluble it is added preferably to the polymerization mixture after the micelles have been formed. The polymerization temperature may vary within broad limits but is usually effected between 20 and 70 °C, a typical polymerization temperature being in the range of 40 to 50 °C.

THe polymerization of the above prepared product (4) monomer being arranged in micellar state is illustrated in the following Example 2.

EXAMPLE 2

To 3 ml of the toluene medium containing the monomer (4) product in inverted micelle form at a CMC of $10^{-4}$ mole/liter were added while stirring 2 mg of 4,4-azobiscyanovaleric acid (polymerization initiator) dissolved in 3 ml of toluene.

The obtained mixture was irradiated for 5 h with ultra-violet radiation in a RAYONET (trade name) laboratory photochemical reactor operating with ultra-violet lamp emitting with wavelength maximum at 350 nm.

The weight average molecular weight ($\overline{M}w$) of the obtained polymer was determined by gel permeation chromatography (GPC). In the above applied polymerization conditions the $\overline{M}w$ was 180,000.

It has been found experimentally that the molecular weight could be increased slightly by increasing the amount of water included in the micelle structure.

It is assumed that the above defined polymerization initiator which is not only oil soluble but also water-soluble concentrates during the polymerization at the interface of the reverse micelles.

The permeability of the polymer skin will largely depend on the polymerization degree, which in its turn

will be determined by the sterical structure of the monomer molecules which has to be such that sterical hindrance by substituents is not prohibitive for the addition reaction between ethylenically unsaturated groups of neighbouring molecules. The concentration of monomeric surfactant in the water-oil interface is defined by the following Gibbs equation :

$$\Gamma = - \frac{1}{R.T} \cdot \frac{d\sigma}{d \ln c}$$

wherein :
$\Gamma$ represents the interface adsorption of the surfactant,
R represents the universal gas constant,
T represents the temperature in degrees Kelvin,
c represents the concentration of surfactant in the continuous phase (oil phase),
$\sigma$ is the interfacial tension between between the oil and water phase.

Particularly useful monomeric emulsifying agents are taking little room in the interface area. The covering degree of an emulsifier molecule can be determined by the following equation :

$$\frac{1}{\bar{A}} = - 0.001074 \cdot \frac{d\sigma}{d \log c}$$

wherein :
A represents the area covered in the interface by one single emulsifier molecule, and c and $\sigma$ have the same significance as given above. [ref. Ullmans Encyklopädie der technischen Chemie, 4. Neubearbeitete und erweiterte Auflage, Band 10 (1975) Verlag Chemie, Weinheim/Bergstr. W. Germany, p. 451.]

According to a particular embodiment for preparing polymer membranes with poor permeability for aqueous liquids the polymerization initiator is dissolved in the aqueous phase and polymerization of the surfactant monomer is effected at the W/O interface in combination with non-surfactant monomer dissolved in the oil phase. Suited non-surfactant monomers for said purpose are styrene and alkyl esters of (meth)-acrylic acid, and for effecting crosslinking reactions, e.g. divinylbenzene, esters of polyols and (meth)acrylic acid and/or butadiene are used.

The polymer emulsions prepared according to the present invention are particularly stable and can be used for coating thin layers of microcapsules. The particle size of the inverted micelles and the microcapsules prepared therewith is e.g. in the range of 10 to 40 nm.

After the polymerization and microcapsule formation an oil soluble film forming binder may be added to the oil phase so that on coating and evaporating the oil type solvent firm layers containing microcapsules on any support can be produced.

According to a particular technique the microcapsules are obtained in the form of a powder by evaporating the oil part or separating them therefrom by filtration or centrifugation. The microcapsule powder can be dispersed in an aqueous medium containing a watersoluble binder, e.g. gelatin to obtain therewith waterpermeable layers on a support.

The aqueous phase of the inverted micelles and lateron of the microcapsules may contain all kind of substances that can be set free from the microcapsules by gradual diffusion through the polymeric membrane or by suddenly breaking or destroying the polymeric capsule wall.

The kind of substance incorporated in the aqueous core of the inverted micelles defines its possible use.

According to an interesting use the inverted micelles prepared according to the present invention are following the polymerization of the monomer(s) without separation from the oil phase used as a liquid electrophoretic toner in the development of electrostatic charge patterns. The oil phase in that case preferably consists of a single hydrocarbon liquid, e.g. isododecane, or mixture of aliphatic hydrocarbon liquids having a boiling range between 150 and 220 °C. In said embodiment the aqueous core phase preferably contains finely dispersed carbon black or dissolved or dispersed dye for the production of coloured toner particles having a particular fine grain size and charge sign defined by the ionic properties of the applied polymerizable monomer acting as emulsifying agent on its own. A dry toner may be prepared by removing the oil phase in a spray dryer combined with a hydrocyclone using a hot inert gas for carrying

along the evaporated oil.

According to another interesting use the inverted micelles prepared according to the present invention are applied before or after polymerization of the monomer(s) in a coating composition containing a binding agent and said composition is coated to form a binder layer of a recording material, e.g. pressure-sensitive, thermosensitive or photosensitive recording material. The aqueous phase of the inverted micelles contains e.g. a colouring substance or at least one chemical reagent for use in colour formation.

According to a particular embodiment the aqueous phase of the inverted micelles contains at least one chemical reagent for use in silver halide photography. For that purpose the micelles or microcapsules derived therefrom are present in a photosensitive material containing at least one silver halide emulsion layer and/or in an image receptor material suited for carrying out a silver complex or dye diffusion transfer process known to those skilled in the art of silver halide photography.

Examples of chemical reagents are e.g. dyes that can be fixed by mordanting, leuco dyes or couplers that may be used for image-wise colour formation on breaking or destroying the capsule walls in pattern-wise fashion. The destruction of the capsule walls may proceed by pressure and/or heat or by high intensity light.

The use of laser light as high intensity light in the destruction of microcapsules is described in US-P 4,621,040. According to the technique described therein an ink set free on rupturing microcapsules is allowed to form a dye image in an ink absorptive layer superposing the microcapsule layer.

According to a special embodiment the microcapsules are used in the production of a photographic silver halide emulsion material and for that purpose contain in their aqueous core a photographically useful reagent. When coated in a waterpermeable hydrophilic colloid layer of the photographic material the reagent is allowed to diffuse, e.g. under wet alkaline or wet acid conditions, into the binder medium of said layer. Photographic reagents that can be used that way are e.g. silver halide complexing agents, silver image stabilizing agents, pH increasing agents, developing agents, development inhibiting agents, anti-fogging agents and silver bleaching agents.

According to another embodiment the microcapsules are used to incorporate pharmaceuticals that are set free gradually, e.g. in the stomach.

According to still another embodiment the microcapsules are used to incorporate all kinds of biocides that have to be delivered slowly to their environment, e.g. the soil or food to be protected against putrefication.

**Claims**

1. Process for the production of inverted micelles by preparing a water-in-oil emulsion of an ionic monomer that can be polymerized, characterized in that the ionic monomer corresponds to the following general formula (I) :

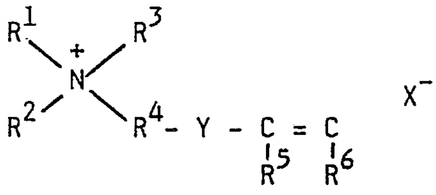

wherein :

each of $R^1$ and $R^2$ - same or different - represents an alkyl group having at least 6 carbon atoms in straight line,

$R^3$ represents a lower (C1-C2) alkyl group,

$R^4$ represents 1 to 4 methylene groups,

each of $R^5$ and $R^6$ - same or different - represents hydrogen or an alkyl group,

Y represents -O-CO-, -CO-O-, -NH-CO-, $-CO-O-CH_2-$, $-O-PO(OR^3)-$ or a phenylene group, and

X- is an anion;

the concentration of said ionic monomer in the oil phase being sufficient to obtain critical micelle concentration, without aid of additional non-polymerizable emulsifying agent.

2. Process according to claim 1, wherein the monomer corresponds to the following structural formula :

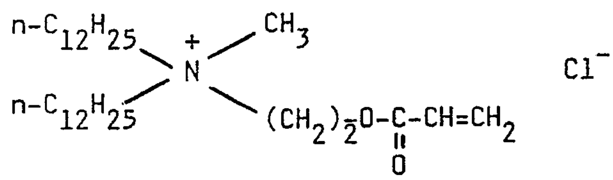

3. Process according to claim 1 or 2, wherein the oil phase of the inverted micelles is a hydrocarbon or halogenated hydrocarbon liquid.

4. Process according to any of the claims 1 to 3, wherein the aqueous phase of the inverted micelles contains at least one colouring substance or chemical reagent for use in colour formation.

5. Process according to any of the claims 1 to 3, wherein the aqueous phase of the inverted micelles contains at least one chemical compound for use in silver halide photography.

6. Process for the production of microcapsules, wherein the ionic monomers of the inverted micelles prepared according to any of claims 1 to 5 are polymerized to form a polymer layer surrounding the aqueous phase core of the micelles.

7. Process according to claim 6, wherein the polymerization is carried out by free radical polymerization known for ethylenic compounds.

8. Process according to claim 6 or 7, wherein the monomer(s) are polymerized thermally or photochemically.

9. Process according to any of the claims 6 to 8, wherein the aqueous phase of the inverted micelles contains at least one colouring substance or chemical reagent for use in colour formation.

10. Process according to any of the claims 6 to 8, wherein the aqueous phase of the inverted micelles contains at least one chemical compound for use in silver halide photography.

11. Recording material containing inverted micelles prepared according to a process of any of the claims 1 to 5, wherein said micelles are present in a coating composition containing a binding agent forming a binder layer in said material.

12. Recording material containing microcapsules prepared according to a process of any of the claims 6 to 10, wherein said microcapsules are present in a coating composition containing a binding agent forming a binder layer in said material.

**Revendications**

1. Procédé pour la production de micelles inversées en préparant une émulsion d'eau-en-huile d'un monomère ionique polymérisable, caractérisé en ce que ce monomère correspond à la formule générale suivante :

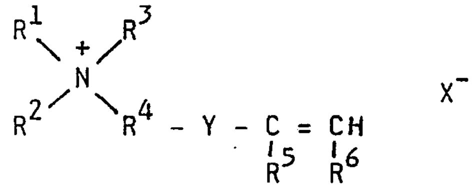

dans laquelle :

chaque $R^1$ et $R^2$ - identique ou différent - représente un groupe d'alkyle avec au moins 6 atomes de carbone en chaîne droite,
$R^3$ représente un groupe d'alkyle court (C1-C2),
$R^4$ représente de 1 à 4 groupes de méthylène,
chaque $R^5$ et $R^6$ - identique ou différent - représente un atome d'hydrogène ou un groupe d'alkyle,
Y représente -O-CO-, -CO-O-, -NH-CO-, -CO-O-$CH_2$-, -O-PO($OR^3$)- ou un groupe de phénylène, et
X- est un anion;
où la concentration du monomère ionique dans la phase oléagineuse doit être suffisante pour obtenir une concentration micellaire critique, sans aide d'agent émulsifiant non-polymérisable supplémentaire.

2. Procédé selon la revendication 1, caractérisé en ce que le monomère correspond à la formule structurale suivante :

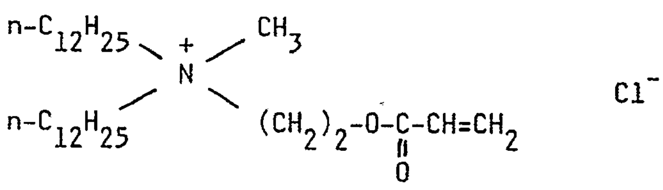

3. Procédé selon la revendication 1 ou 2, caractérisé en ce que la phase oléagineuse des micelles inversées est un liquide d'hydrocarbure ou d'hydrocarbure halogéné.

4. Procédé selon l'une quelconque des revendications 1 à 3, caractérisé en ce que la phase aqueuse des micelles inversées contient au moins un colorant ou un réactif chimique convenant pour la formation de colorants.

5. Procédé selon l'une quelconque des revendications 1 à 3, caractérisé en ce que la phase aqueuse des micelles inversées contient au moins un produit chimique appliqué en photographie à base d'halogénures d'argent.

6. Procédé pour la production de microcapsules, caractérisé en ce que les monomères ioniques des micelles inversées, préparées selon l'une quelconque des revendications 1 à 5, sont polymérisés pour former une couche de polymère enveloppant le noyau de la phase aqueuse des micelles.

7. Procédé selon la revendication 6, caractérisé en ce que la polymérisation se réalise au moyen de radicaux libres comme connu pour les produits éthyléniques.

8. Procédé selon la revendication 6 ou 7, caractérisé en ce que les monomères sont polymérisés d'une façon thermique ou photochimique.

9. Procédé selon l'une quelconque des revendications 6 à 8, caractérisé en ce que la phase aqueuse des micelles inversées contient au moins un colorant ou un réactif chimique convenant pour la formation de colorants.

10. Procédé selon l'une quelconque des revendications 6 à 8, caractérisé en ce que la phase aqueuse des micelles inversées contient au moins un produit chimique appliqué en photographie à base d'halogénures d'argent.

11. Matériau d'enregistrement contenant des micelles inversées, préparées selon un procédé d'une quelconque des revendications 1 à 5, caractérisé en ce que les micelles précitées se trouvent dans une composition de coulée contenant un liant qui forme une couche à base de liant dans ce matériau d'enregistrement.

12. Matériau d'enregistrement contenant des microcapsules préparées selon un procédé d'une quelconque

des revendications 6 à 10, caractérisé en ce que les microcapsules se trouvent dans une composition de coulée contenant un liant qui forme une couche à base de liant dans ce matériau d'enregistrement.

## Patentansprüche

1. Verfahren zur Herstellung umgekehrter Mizelle durch Herstellung einer Wasser-in-Öl-Emulsion eines polymerisierbaren ionischen Monomeren, dadurch gekennzeichnet, daß dieses ionische Monomere der folgenden allgemeinen Formel (I) entspricht :

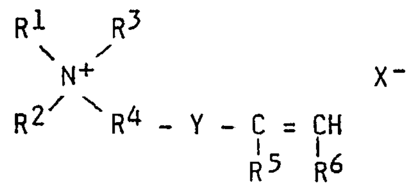

in der bedeuten :
$R^1$ und $R^2$ - gleich oder verschieden - je eine Alkylgruppe mit mindestens 6 Kohlenstoffatomen in geradliniger Kette,
$R^3$ eine niedere ($C_1$-$C_2$) Alkylgruppe,
$R^4$ 1 bis 4 Methylengruppen,
$R^5$ und $R^6$ - gleich oder verschieden - je Wasserstoff oder eine Alkylgruppe,
Y -O-CO-, -CO-O-, -NH-CO-, -CO-O-$CH_2$-, -O-PO($OR^3$)- oder eine Phenylengruppe, und
X- ein Anion; wobei
die Konzentration des ionischen Monomeren in der Öl-Phase ausreicht zum Erreichen der kritischen Mizell-Konzentration, ohne Hilfe eines zusätzlichen nicht-polymerisierbaren Emulgiermittels.

2. Verfahren nach Anspruch 1, dadurch gekennzeichnet, daß das Monomere der folgenden Strukturformel entspricht :

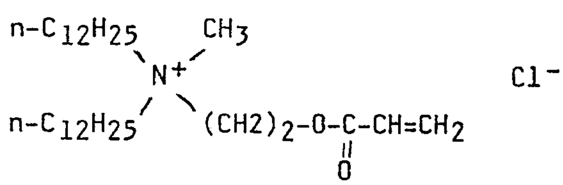

3. Verfahren nach Ansprüche 1 oder 2, dadurch gekennzeichnet, daß die Öl-Phase der umgekehrten Mizelle ein flüssiger Kohlenwasserstoff oder halogenierter Kohlenwasserstoff ist.

4. Verfahren nach irgendeinem der Ansprüche 1 bis 3, dadurch gekennzeichnet, daß die wäßrige Phase der invertierten Mizelle mindestens eine farbige Substanz oder mindestens ein chemisches Reagenz zur Anwendung bei der Farbbildung enthält.

5. Verfahren nach irgendeinem der Ansprüche 1 bis 3, dadurch gekennzeichnet, daß die wäßrige Phase der invertierten Mizelle mindestens eine chemische Verbindung zur Anwendung in der Silberhalogenid-Photographie enthält.

6. Verfahren zur Herstellung von Mikrokapseln, dadurch gekennzeichnet, daß die ionischen Monomeren der invertierten Mizelle, hergestellt nach irgendeinem der Ansprüche 1 bis 5, polymerisiert werden zur Bildung einer Polymerschicht, die den Kern aus wäßriger Phase der Mizelle umhüllt.

7. Verfahren nach Anspruch 6, dadurch gekennzeichnet, daß die Polymerisation durch die für ethylenische Verbindungen bekannte Freiradikal-Polymerisation stattgefunden hat.

8. Verfahren nach Ansprüchen 6 oder 7, dadurch gekennzeichnet, daß das Monomere oder die Monomeren nach einem thermischen oder photochemischen Verfahren polymerisiert sind.

9. Verfahren nach irgendeinem der Ansprüche 6 bis 8, dadurch gekennzeichnet, daß die wäßrige Phase der invertierten Mizelle mindestens eine farbige Substanz oder mindestens ein chemisches Reagenz zur Anwendung bei der Farbbildung enthält.

10. Verfahren nach irgendeinem der Ansprüche 6 bis 8, dadurch gekennzeichnet, daß die wäßrige Phase der invertierten Mizelle mindestens eine chemische Verbindung zur Anwendung in der Silberhalogenid-Photographie enthält.

11. Aufzeichnungsmaterial, das invertierte Mizelle, hergestellt gemäß einem Verfahren nach irgendeinem der Ansprüche 1 bis 5 enthält, dadurch gekennzeichnet, daß diese Mizelle in einer Gießzusammensetzung enthalten sind, die ein Bindemittel zur Bildung einer Bindemittelschicht in diesem Material enthält.

12. Aufzeichnungsmaterial, das Mikrokapseln, aufbereitet gemäß einem Verfahren nach irgendeinem der Ansprüche 6 bis 10 enthält, dadurch gekennzeichnet, daß diese Mikrokapseln in einer Gießzusammensetzung enthalten sind, die ein Bindemittel zur Bildung einer Bindemittelschicht in diesem Material enthält.

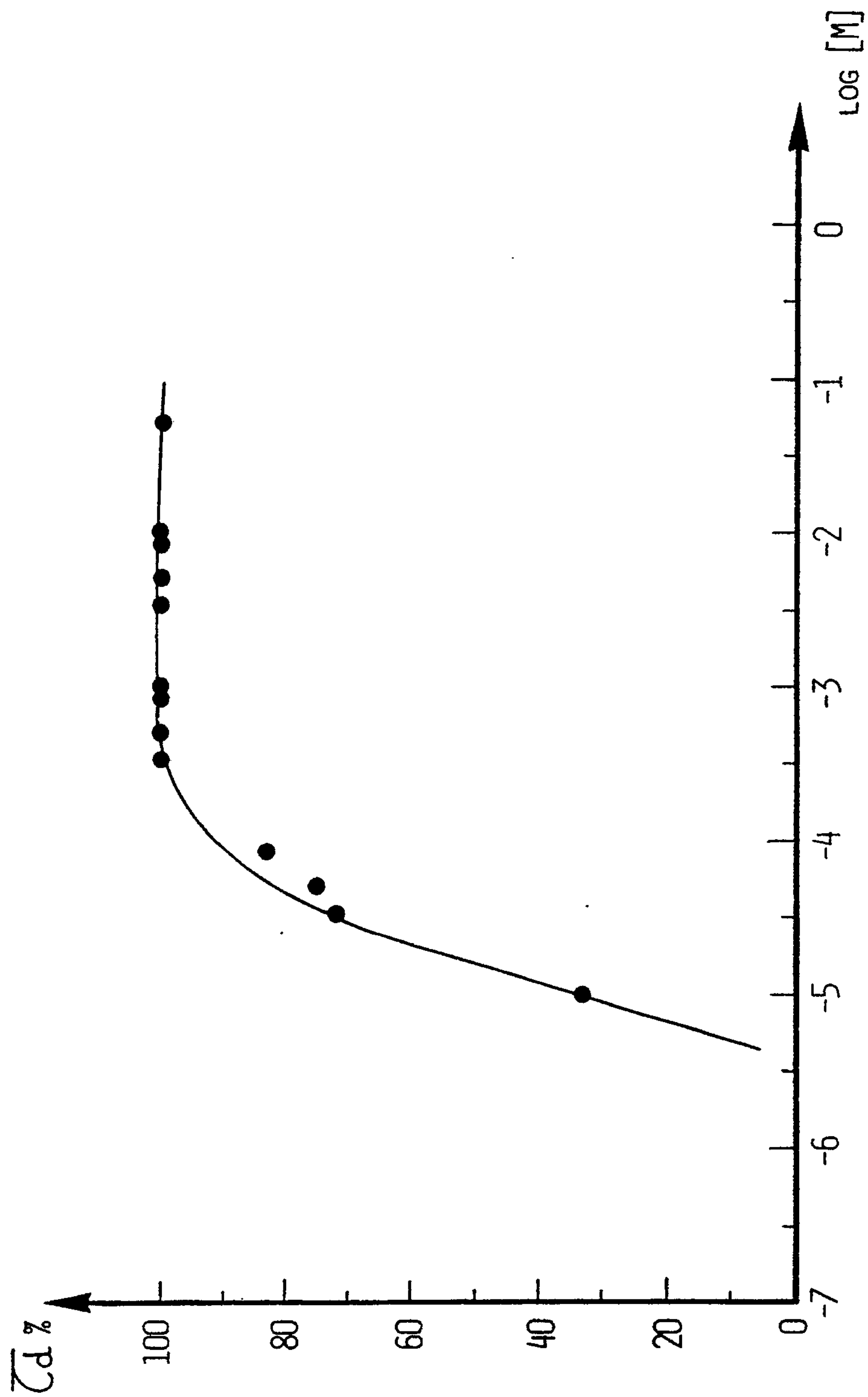
LOG [M]
0
-1
-2
-3
-4
-5
-6
-7
100
80
60
40
20
0